# FASCICULE DE BREVET EUROPEEN

(11) **EP 1 109 946 B1**
(45) Date de publication et mention de la délivrance du brevet: **07.05.2003**
(21) Numéro de dépôt: 99940278.7
(22) Date de dépôt: 02.09.1999
(51) Int. Cl.: C23C 14/50, G02B 7/02, G02C 13/00

(54) **SUPPORT POUR LENTILLE OPTIQUE, ET SON PROCEDE DE MISE EN OEUVRE**
UNTERSTÜTZUNG FÜR EINE OPTISCHE LINSE UND VERFAHREN ZU DEREN BETRIEB
OPTICAL LENS SUPPORT AND METHOD FOR USING SAME

(30) Priorité: 04.09.1998 FR 9811099
(43) Date de publication de la demande: 27.06.2001
(73) Titulaire: ESSILOR INTERNATIONAL (Compagnie Générale d'Optique), F-94220 Charenton-le-Pont (FR)
(72) Inventeur: WILLEMIN, Gérard, F-94500 Champigny (FR); KELLER, Gerhard, F-94100 Saint Maur (FR); MENGES, Gilles, F-55200 Commercy (FR); LAMETAIRIE, Patrick, F-94500 Champigny (FR); MACE, Michel, F-77500 Chelles (FR); DUON, Jean-Claude, F-91590 Mondeville (FR); OURIVES, Pedro, F-77340 Pontault-Combault (FR)
(74) Mandataire: Santarelli
(86) Numéro de dépôt international: FR9902093
(87) Numéro de publication internationale: WO00014295

(56) Documents cités:
- EP-A- 0 547 312
- US-A- 2 532 971
- US-A- 5 124 019

## Description

La présente invention concerne d'une manière générale les supports pour lentille optique, et, plus particulièrement, pour lentille ophtalmique.

Ainsi qu'on le sait, il est usuel, après leur fabrication, d'appliquer, aux lentilles ophtalmiques, un quelconque traitement, pour leur conférer des caractéristiques particulières, et, par exemple, des propriétés de résistance à l'abrasion et/ou des propriétés antireflet.

Par lentille ophtalmique, on entend ici, plus particulièrement, de manière conventionnelle, un palet dont est ensuite issu, par détourage, un verre de lunettes à monter sur une quelconque monture de lunettes.

Le plus souvent, ce palet a, périphériquement, un contour circulaire, mais il n'en est pas toujours obligatoirement ainsi.

Dans ce qui suit, ce contour devra donc être considéré comme quelconque.

Quoi qu'il en soit, l'application d'un traitement à une lentille ophtalmique implique le plus souvent le dépôt d'au moins une couche de matériau à la surface de celle-ci, et il importe, évidemment, que ce dépôt se fasse avec une très bonne uniformité.

Traditionnellement, pour un antireflet, ce dépôt est effectué sous vide.

Cela est le cas, par exemple, dans le brevet américain No 2 532 971, dans lequel les lentilles ophtalmiques à traiter sont chacune disposées dans un support individuel apte à en assurer le maintien tout au long de leur traitement.

Ce traitement implique en pratique une rotation de ces lentilles ophtalmiques à une vitesse relativement modérée, qui est de l'ordre de 50 tours/min, par rapport à l'axe de rotation du support collectif sur lequel l'ensemble est ensuite rapporté.

Pour chacune de ces lentilles ophtalmiques, le support individuel comporte, globalement, une embase, et, portés par celle-ci, pour la saisie d'une telle lentille ophtalmique par sa tranche, trois plots d'appui, dont un est fixe par rapport à l'embase tout en étant éventuellement réglable en position par rapport à celle-ci, et dont les deux autres sont chacun individuellement portés par des bras élastiquement déformables eux-mêmes portés par l'embase.

En pratique, cette embase se présente sous la forme générale d'une bague de contour globalement circulaire dont la dimension radiale, c'est-à-dire la dimension suivant son épaisseur, et, donc, suivant le plan de ses tranches, est très largement inférieure à sa hauteur, c'est-à-dire à sa dimension suivant une perpendiculaire à ce plan.

En pratique, également, devant lui-même être rapporté dans un anneau, ce support individuel en forme générale de bague n'intervient jamais par la tranche de son embase.

Il en reste sensiblement de même dans les réalisations plus récentes, telles que, par exemple, celle décrite dans le brevet américain No 5 325 812, dans lequel un tel support individuel pour lentille ophtalmique se réduit en pratique à une simple bague élastiquement déformable à rapporter dans un anneau de support rigide.

Toujours dans le cas d'un dépôt effectué sous vide, le brevet américain No 5 660 693 propose un mode de réalisation où le support de lentille comporte un corps principal ayant la forme générale d'un disque. Ce corps principal est traversé par un trou de repérage propre à recevoir un doigt de positionnement appartenant à la platine rotative collective. Trois doigts de rétention de la lentille sont prévus sur le support. Ils sont montés chacun dans une fente du corps principal orientée radialement afin que l'on puisse ajuster le positionnement des doigts de rétention par des moyens tels qu'une tige fileté disposée sur la face inférieure du corps principal.

Il s'est développé, par ailleurs, mais pour d'autres types de substrat, en l'espèce des plaquettes de silicium destinées à être utilisées dans le domaine de la micro-électronique, une autre technique de dépôt d'une couche de matériau, communément dite "spin coating", suivant laquelle on met en rotation le substrat à traiter et on dépose à sa surface une faible quantité du matériau à mettre en oeuvre.

Généralement, la vitesse de rotation du substrat durant la phase d'étalement de ce matériau, supérieure à sa vitesse de rotation lors du dépôt de celui-ci, est relativement élevée, en étant en pratique toujours supérieure à 1 500 tours/min, pour assurer une répartition convenable du matériau à l'ensemble de la surface du substrat.

Eu égard à la vitesse de rotation élevée ainsi mise en oeuvre, il importe, évidemment, que le support individuel des substrats à traiter dispose d'une bonne assise au sein de l'appareillage correspondant.

Pour l'application d'un traitement par "spin coating" à une lentille ophtalmique, un support en forme générale de bague, du genre de ceux qui, tels que succinctement exposés ci-dessus, sont usuellement mis en oeuvre à ce jour pour le maintien d'une telle lentille ophtalmique, ne saurait évidemment pas non plus convenir, en raison de la faible assise qu'il offre.

Pour l'application d'un tel traitement par "spin coating" à une lentille ophtalmique, il est décrit, dans la demande de brevet allemand No 38 38 012, un support comportant trois éléments de serrage dont chacun est constitué d'un doigt de support, qui reçoit la lentille ophtalmique, et d'un doigt de serrage, qui pince celle-ci, avec un dispositif à masselottes qui permet de faire varier la pression exercée sur elle en fonction de la vitesse de rotation.

Il en résulte globalement une réalisation particulièrement complexe.

La présente invention a d'une manière générale pour objet un support pour lentille optique susceptible au contraire d'assurer de manière simple un maintien convenable d'une telle lentille optique, même au sein d'un appareillage mettant en oeuvre la technique de dépôt par "spin coating".

Ce support pour lentille optique, qui est du genre comportant au moins une première embase, et, portés par celle-ci, pour le maintien d'une telle lentille optique, au moins trois plots d'appui est d'une manière générale caractérisé en ce que l'embase comporte, pour sa propre assise, une surface d'appui, qui est plane, et dont le contour périphérique est globalement circulaire, et en ce que la dimension radiale de ladite embase suivant un quelconque rayon de cette surface d'appui est au moins égale à la dimension axiale de ladite embase suivant une perpendiculaire à ladite surface d'appui.

On obtient ainsi une surface d'assise suffisante pour permettre la mise en oeuvre du support au sein d'un appareillage mettant en oeuvre la technique de "spin coating". Le support peut en particulier être fixé par sa seule surface d'appui sur un plateau tournant d'appareillage de "spin coating" formant une ventouse pneumatique, c'est-à-dire présentant une pluralité d'orifices d'aspiration maintenant l'embase contre ledit plateau par succion de sa surface d'appui.

Il est même avantageusement possible, grâce au support pour lentille optique suivant l'invention, de pouvoir utiliser un appareillage de ce type déjà existant, sans une quelconque adaptation sensible de celui-ci, en bénéficiant ainsi, dans le domaine des lentilles optiques, d'une technologie déjà éprouvée dans un autre domaine.

D'une manière plus générale, il est avantageusement possible, grâce au support pour lentille optique suivant l'invention, de se satisfaire de vitesses de rotation relativement élevées.

De ce point de vue, la présente invention a encore pour objet un procédé de mise en oeuvre de ce support caractérisé en ce qu'il implique une rotation de ce support et de la lentille optique qu'il porte à une vitesse de rotation supérieure à 500 tours/min.

Dans un premier type de réalisation, parmi les trois plots d'appui, un au moins est fixe par rapport à l'embase, et un autre, au moins, est porté par un élément élastiquement déformable lui-même porté par l'embase.

Préférentiellement alors, et pour certaines applications, au moins, deux des plots d'appui que comporte le support pour lentille optique suivant l'invention sont fixes, seul le troisième de ces plots d'appui étant porté par un élément élastiquement déformable.

Il est ainsi avantageusement possible de mieux maîtriser l'effort élastique auquel est soumise la lentille optique, alors même que, eu égard, d'une part, à la température à laquelle elle est soumise, qui peut atteindre 100°C, et, d'autre part, au fait que cet effort élastique lui est appliqué sur sa tranche, qui, pour certaines prescriptions, au moins, peut être très mince, cette lentille optique peut se trouver dangereusement fragilisée et qu'il est donc souhaitable de la ménager.

Préférentiellement, également, les plots d'appui que comporte le support pour lentille optique suivant l'invention interviennent suivant une circonférence excentrée par rapport à la périphérie de l'embase, c'est-à-dire par rapport à la périphérie de la surface d'appui de celle-ci, le centre de cette circonférence se situant plus près du ou des plots d'appui fixes que le centre de cette périphérie.

En effet, de bons résultats ont été obtenus avec un tel décentrement de la lentille optique dans son support.

Préférentiellement, également, l'embase du support pour lentille optique suivant l'invention est ajourée par une ouverture centrale, et le ou les plots d'appui fixes sont en bordure de celle-ci, tandis que le ou les plots d'appui portés par un élément élastiquement déformable s'étendent dans le contour même de cette ouverture centrale.

Il est ainsi avantageusement possible de traiter en continu les deux faces de la lentille optique, en procédant à un simple retournement de l'ensemble qu'elle forme avec son support.

En outre, lorsque deux plots d'appui fixes sont ainsi mis en oeuvre, les vibrations parasites en service sont avantageusement diminuées, au bénéfice d'une meilleure stabilité de l'ensemble lors de la rotation correspondante.

Enfin, la minceur relative de l'embase du support pour lentille optique suivant l'invention est par ailleurs avantageusement favorable à un rangement de ce support par sa tranche dans un quelconque casier de rangement, de type panier, comportant, de place en place, suivant un pas régulier, des rainures à la faveur de chacune desquelles peut être engagé un tel support.

Dans un second type de réalisation, les trois plots d'appui sont fixes sur l'embase et présentent chacun une face d'appui radial et une face d'appui axial, les faces d'appui axial des différents plots offrant à la périphérie de la lentille une assise suivant un plan donné parallèle à la surface d'appui de l'embase. On obtient ainsi, notamment aux vitesses de rotation élevées, un maintien plus rigide et plus fiable de la lentille.

L'embase se présentant sous la forme d'un disque plein, le plan d'assise offert par les faces d'appui axial des plots s'étend légèrement à distance de cette autre face de l'embase.

L'embase se présentant sous la forme générale d'un disque ajourée par une ouverture centrale délimitée par une bordure intérieure sensiblement de même forme et de même dimension que la lentille, les plots d'appui sont réalisés chacun en deux parties, avec une première partie qui fait saillie de l'autre face de l'embase et présente la face d'appui radial du plot concerné et une seconde partie qui s'étend en saillie radiale de la bordure intérieure de l'embase. Avantageusement alors, l'embase se présentant sous la forme générale d'un disque ajourée par une ouverture centrale délimitée par une bordure intérieure sensiblement de même forme et de même dimension que la lentille, les plots d'appui sont réalisés chacun en deux parties, avec une première partie qui fait saillie de l'autre face de l'embase et présente la face d'appui radial du plot concerné et une seconde partie qui s'étend en saillie radiale de la bordure intérieure de l'embase.

Avantageusement encore, la seconde partie de chaque plot est réalisée en une seule pièce avec l'embase. Ces faces d'appui axial en biseau offrent ainsi à la lentille un siège pseudo-conique qui réduit son contact avec ces faces d'appui axial à une ligne, voire un simple point, situé sur son bord périphérique. Sa face inférieure est ainsi préservée de tout contact qui risquerait de détériorer son traitement de surface.

Dans un perfectionnement avantageux, et toujours dans le cas où les trois plots d'appui sont fixes, le support comporte une seconde embase analogue à la première, pourvue d'au moins trois plots d'appui pour le maintien de la lentille et comportant, pour sa propre assise, une surface d'appui plane dont le contour périphérique est globalement circulaire, sa dimension radiale suivant un quelconque rayon de cette surface d'appui étant au moins égale à sa dimension axiale suivant une perpendiculaire au plan de celle-ci ; les plots de la seconde embase présentent des faces d'appui axial offrant à la lentille une assise suivant un plan parallèle à la surface d'appui de l'embase pour sa propre assise ; les deux embases sont pourvues de moyens de leur assemblage en superposition, avec la surface d'appui de chaque embase tournée à l'opposé de l'autre embase, de telle sorte que les deux assises offertes par les faces d'appui axial des plots des deux embases prennent la périphérie de la lentille en sandwich.

La lentille est ainsi prise en sandwich entre les deux embases qui lui offrent chacune, par les faces d'appui axial de leurs plots, une assise suivant un plan parallèle à leur surface d'appui. L'ensemble du support, avec ses deux embases et la lentille placée entre celle-ci, peut ainsi être retourné pour le traitement successif des deux faces de la lentille. Pour traiter une première face de la lentille, le support est disposé de telle sorte que la première embase soit située en-dessous de la première, avec sa surface d'appui reposant sur le plateau tournant de l'appareillage, la lentille reposant sur les faces d'appui axial des plots de cette première embase. Après traitement de cette première face de la lentille, l'ensemble du support est retourné de manière que sa seconde embase se retrouve en-dessous de la première, avec sa surface d'appui reposant sur le plateau tournant de l'appareillage. La lentille repose alors sur la face d'appui axial des plots de cette seconde embase et sa seconde face peut être traitée.

Avantageusement alors, les deux plans des assises offertes par les faces d'appui axial des plots des deux embases sont distants l'un de l'autre d'une distance légèrement supérieure à l'épaisseur de la lentille, de sorte que celle-ci jouit d'un certain jeu axial entre les deux plans d'assise associés aux deux embases. De cette manière, quelle que soit la position du support, la face supérieure de la lentille est entièrement dégagée des faces d'appui axial des plots de l'embase qui se trouvent au-dessus d'elle et est seulement en contact par sa face inférieure, qui n'est pas traitée, avec les faces d'appui axial des plots de l'embase qui reposent sur le plateau tournant de l'appareillage de "spin coating".

Avantageusement encore, les moyens d'assemblage des deux embases l'une sur l'autre font intervenir les plots d'appui. On fait ainsi exercer aux plots d'appui une seconde fonction contribuant à l'assemblage des deux embases.

Dans un mode d'exécution avantageux reprenant cette dernière caractéristique, les plots d'appui de la première embase comportent chacun un ergot qui s'étend parallèlement à l'axe central, à l'opposé de la surface d'appui de l'embase, et qui porte la face d'appui radial du plot concerné, et les plots de la seconde embase comportent chacun une borne portant la face d'appui axial du plot concerné et présentant un logement axial de réception de l'ergot d'un plot correspondant de la première embase.

De préférence alors, dans le cas où on souhaite ménager un jeu axial entre les plans d'assise associés aux deux embases, l'écartement des deux embases et, partant, des plans d'assise qui sont offerts par les face d'appui axial de leur plot, est déterminé par la butée de l'extrémité libre des ergots des plots de la première embase contre un fond des logements des bornes des plots de la seconde embase.

Selon une autre caractéristique avantageuse, les faces d'appui axial des plots de la seconde embase sont en biseau. Comme expliqué précédemment pour les plots de la première embase, le fait que les faces d'appui axial des plots de la seconde embase soient taillées en biseau permet d'offrir à la lentille un siège pseudo-conique qui réduit son contact avec ces faces d'appui axial à une ligne, voire même à un simple point, située sur son bord périphérique. Sa face inférieure, qui vient éventuellement d'être traitée avant le retournement du support, est ainsi préservé de tout contact qui risquerait de détériorer son traitement de surface.

Dans un mode d'exécution préféré, chacune des deux embases se présente sous la forme générale d'un disque ajouré par une ouverture centrale délimitée par une bordure intérieure sensiblement de même forme et de même dimension que la lentille.

L'invention vise également, sous un autre aspect, l'utilisation, dans les conditions expliquées ci-dessus, du support qui vient d'être exposé dans un appareillage mettant en oeuvre la technique du "spin coating".

Les objets de l'invention, et leurs caractéristiques et avantages, ressortiront d'ailleurs de la description qui va suivre, à titre d'exemple, en référence aux dessins schématiques annexés sur lesquels :
la figure 1 est une vue en perspective d'une lentille optique à laquelle est destiné le support suivant l'invention ;
la figure 2 est une vue en perspective du support selon un premier mode de réalisation de l'invention, dans lequel le support comporte un plot mobile ;
la figure 3 en est, à échelle supérieure, une vue en coupe transversale, suivant la ligne III-III de la figure 2 ;
la figure 4 est une vue en plan illustrant la mise en place d'une lentille optique sur ce support ;
la figure 5 est une vue en perspective analogue à celle de la figure 2, illustrant un second mode de réalisation de l'invention ;
la figure 6 est une vue en coupe transversale de ce second mode de réalisation, suivant la ligne VI-VI de la figure 5 ;
les figures 7 et 8 sont des vues partielles en coupe transversale, qui, analogues à celle de la figure 6, correspondent, chacune respectivement, au troisième et quatrième modes de réalisation de l'invention ;
la figure 9 est une vue en plan du support selon un cinquième mode de réalisation de l'invention ;
la figure 10 est une vue en perspective qui, analogue à celle de la figure 2, concerne un sixième mode de réalisation de l'invention ;
la figure 11 est une vue en perspective qui, analogue, elle aussi, à celle de la figure 2, concerne un septième mode de réalisation de l'invention ;
la figure 12 est une vue en plan illustrant la mise en oeuvre de ce septième mode de réalisation ;
la figure 13 est une vue en perspective d'un support pour lentille optique selon un huitième mode de réalisation de l'invention, dans lequel tous les plots sont fixes sur l'embase ;
la figure 14 est une vue en perspective éclatée d'un support pour lentille optique selon un neuvième mode de réalisation de l'invention, dans lequel la lentille est prise entre deux embases à plots fixes ;
la figure 15 est une demi-vue en coupe par un plan axial du support de la figure 14 ;
la figure 16 est une vue analogue à la figure 15, le support ayant été retourné, de sorte que la seconde embase se trouve en-dessous de la première embase et que la lentille repose sur les faces d'appui axial des plots de la seconde embase et est légèrement décollée des faces d'appui axial des plots de la première embase.

Tel qu'illustré sur ces figures, il s'agit, globalement, d'assurer un maintien convenable d'une quelconque lentille optique 10.

Cette lentille optique 10, qui est, plus précisément, une lentille ophtalmique, est par exemple concavo-convexe.

Mais elle pourrait tout aussi bien être par exemple biconcave ou biconvexe.

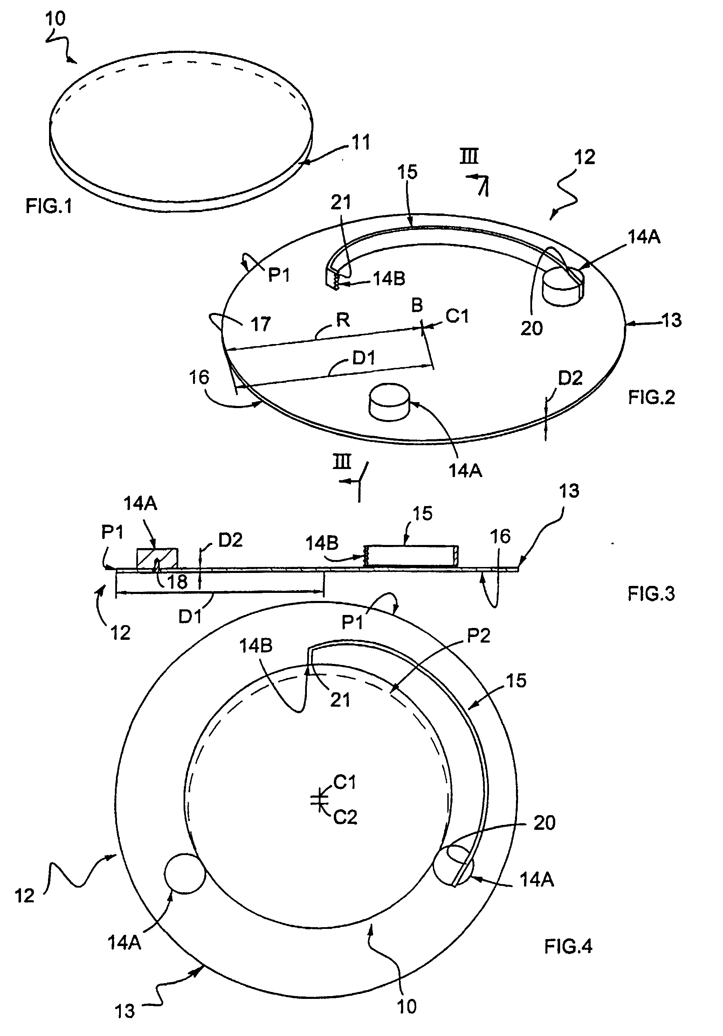

Dans la forme de réalisation plus particulièrement représentée sur la figure 1, il s'agit, à titre d'exemple, d'une lentille optique 10 de contour circulaire.

En pratique, cette lentille optique 10 constitue un palet dans lequel sera usiné, par détourage, un verre de lunettes de contour adapté à celui des cercles ou entourages d'une quelconque monture de lunettes à équiper.

Soit 11 sa tranche, qui est plus ou moins épaisse, ou plus ou moins mince, suivant les prescriptions.

De manière connue en soi, le support 12 mis en oeuvre pour un maintien individuel convenable d'une telle lentille optique 10 comporte, globalement, une embase 13, et, portés par celle-ci, pour la saisie d'une telle lentille optique 10 par sa tranche 11, au moins trois plots d'appui 14A, 14B, dont un au moins est fixe par rapport à l'embase 13, et dont un autre, au moins, est porté par un bras élastiquement déformable 15, lui-même porté par l'embase 13.

Dans les diverses formes de réalisation représentées, seuls trois plots d'appui 14A, 14B ont été prévus.

Suivant l'invention, l'embase 13 comportant, pour sa propre assise, une surface d'appui 16, qui est plane, et dont le contour périphérique P1 est globalement circulaire, sa dimension radiale D1 suivant un quelconque rayon R de cette surface d'appui 16 est au moins égale à sa dimension axiale D2 suivant une perpendiculaire au plan de celle-ci.

En pratique, la dimension radiale D1 de l'embase 13 est un multiple, qui peut aller jusqu'à dix par exemple, de sa dimension axiale D2.

Par exemple, la dimension radiale D1 est comprise entre 50 et 60 mm, et la dimension axiale D2 entre 1 et 5 mm.

Mais, bien entendu, ces valeurs numériques ne sont données ici qu'à titre d'exemple, sans qu'il puisse en résulter une quelconque limitation de l'invention.

Dans la forme de réalisation plus particulièrement représentée sur les figures 1 à 4, l'embase 13 est un disque plat et plein, dont la surface inférieure forme la surface d'appui 16.

Soit C1 son centre.

Il s'agit, en pratique, du centre du contour périphérique P1 de sa surface d'appui 16, et il correspond au centre de rotation du support 12.

Dans la forme de réalisation plus particulièrement représentée sur les figures 1 à 4, deux des plots d'appui 14A, 14B sont fixes, seul le troisième étant porté par un bras élastiquement déformable 15.

Soit 14A les plots d'appui fixes, et 14B le plot d'appui porté par un bras élastiquement déformable 15.

Par exemple, et tel que représenté, les plots d'appui 14A fixes sont des bossages cylindriques, dont la section transversale est circulaire, et dont les génératrices s'étendent perpendiculairement à l'embase 13.

Dans la forme de réalisation représentée, les deux plots d'appui 14A fixes sont identiques l'un à l'autre, et il s'agit de tronçons de cylindre droits qui sont chacun dûment rapportés sur l'embase 13 par un quelconque moyen de fixation 18, une vis par exemple, figure 3.

Dans la forme de réalisation plus particulièrement représentée sur les figures 1 à 4, le bras élastiquement déformable 15 portant le troisième plot d'appui 14B est ancré à sa racine dans l'un des plots d'appui 14A fixes.

Par exemple, et tel que représenté, ce bras élastiquement déformable 15 est formé par une lame de ressort dont la largeur s'étend perpendiculairement au plan de la surface d'appui 16 de l'embase 13.

En pratique, ce bras élastiquement déformable 15 est emboîté, à sa racine, dans le plot d'appui 14A fixe qui le porte, à la faveur d'une saignée 20 de ce plot d'appui 14A fixe, et il s'étend librement en porte à faux à compter de ce dernier, suivant un contour qui est, globalement, un contour en arc de cercle, et suivant un secteur circulaire dont l'angle au centre est supérieur à 45°, en étant par exemple de l'ordre de 90°.

Dans la forme de réalisation représentée, le plot d'appui 14B ainsi porté par un bras élastiquement déformable 15 est d'un seul tenant avec celui-ci, en formant une seule et même pièce avec ce bras élastiquement déformable 15.

En pratique, le plot d'appui 14B est simplement formé par un retour en équerre de l'extrémité libre du bras élastiquement déformable 15, dirigé vers le centre C1 de l'embase 13.

Préférentiellement, l'un au moins des plots d'appui 14A, 14B ainsi constitués présente localement au moins une encoche 21, pour une meilleure tenue de la lentille optique 10.

Dans la forme de réalisation plus particulièrement représentée sur les figures 1 à 4, il en est ainsi pour le seul le plot d'appui 14B porté par un bras élastiquement déformable 15, et celui-ci présente en pratique plusieurs encoches 21, qui sont échelonnées sur sa hauteur, et qui ont chacune un profil en V.

Corollairement, dans la forme de réalisation représentée, les plots d'appui 14A fixes sont lisses.

Préférentiellement, les plots d'appui 14A, 14B, au repos, c'est-à-dire en l'absence de lentille optique 10, interviennent suivant une circonférence P2 excentrée par rapport au contour périphérique P1 de la surface d'appui 16 de l'embase 13, le centre C2 de cette circonférence P2 se situant plus près des plots d'appui 14A fixes que le centre C1 de ce contour périphérique P1.

Par exemple, l'excentrement intervenant ainsi entre le centre C2 de la circonférence P2 sur laquelle se situent au repos les plots d'appui 14A, 14B et le centre C1 du contour périphérique P1 de la surface d'appui 16 de l'embase 13 est compris entre 1 et 5 mm, en étant préférentiellement de l'ordre de 1 à 2 mm.

Mais, comme précédemment, ces valeurs numériques ne sont données ici qu'à titre d'exemple, sans qu'il puisse en résulter une quelconque limitation de l'invention.

L'embase 13 est par exemple métallique, et il en est de même pour le bras élastiquement déformable 15.

Par exemple, l'embase 13 peut être en aluminium.

Mais elle peut également être en matière synthétique, si la température le permet.

Quant aux plots d'appui 14A fixes, ils peuvent par exemple être eux aussi en matière synthétique, si la température le permet.

Quoi qu'il en soit, en service, et tel que représenté sur la figure 4, la lentille optique 10 à maintenir est simplement insérée, par sa tranche 11, entre les plots d'appui 14A fixes et le plot d'appui 14B porté par un bras élastiquement déformable 15, et, sous la sollicitation de ce dernier, elle vient porter de manière positive contre les plots d'appui 14A fixes le long d'une génératrice de chacun de ceux-ci.

Par exemple, la force radiale déployée à cet effet par le bras élastiquement déformable 15 est comprise entre 1 et 10 N, en étant préférentiellement de l'ordre de 2 N.

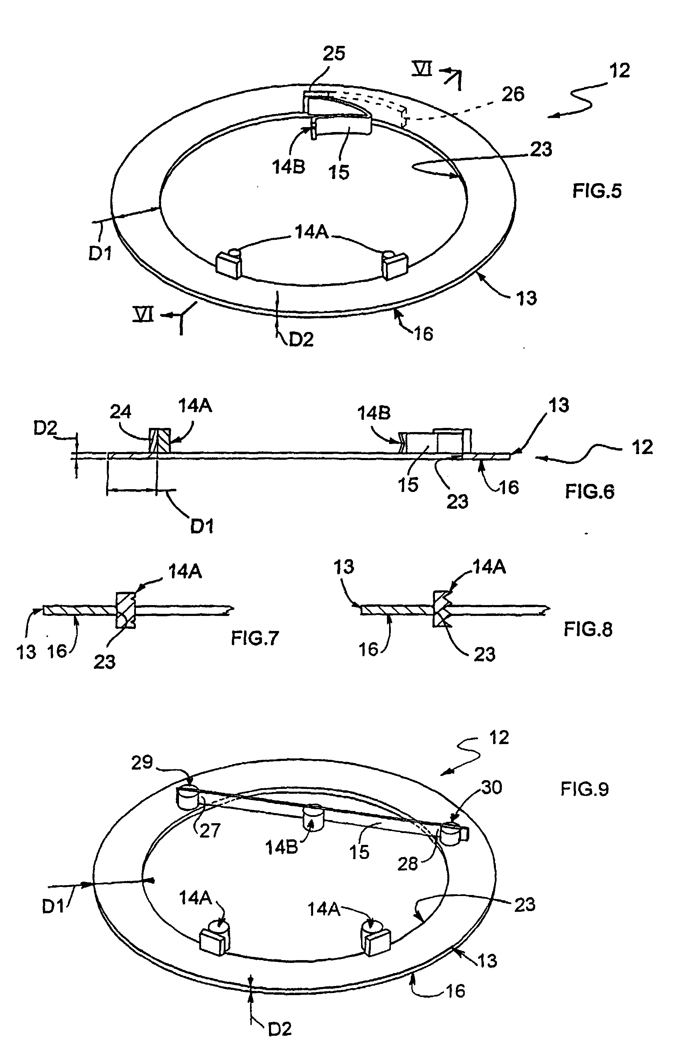

Dans les formes de réalisation représentées sur les figures 5 à 8, l'embase 13 est ajourée par une large ouverture centrale 23, et elle a donc la forme générale d'une rondelle.

La surface d'appui 16 est alors formée par sa surface inférieure ou supérieure.

Conjointement, le ou les plots d'appui 14A fixes s'étendent en bordure de cette ouverture centrale 23, le ou les plots d'appui 14B portés par un bras élastiquement déformable 15 s'étendant dans le contour même de celle-ci.

Par exemple, et tel que représenté, il y a, comme précédemment, deux plots d'appui 14A fixes et un plot d'appui 14B porté par un bras élastiquement déformable 15.

Dans la forme de réalisation plus particulièrement représentée sur la figure 6, les plots d'appui 14A fixes s'étendent entièrement d'un même côté de l'embase 13, et il en est de même pour le plot d'appui 14B porté par un bras élastiquement déformable 15.

Dans la forme de réalisation représentée, les plots d'appui 14A fixes sont chacun individuellement solidaires d'un flasque 24 par lequel ils sont rapportés sur l'embase 13.

Comme précédemment, il s'agit de tronçons de cylindre droits et lisses.

Corollairement, dans la forme de réalisation représentée, entre sa racine et le plot d'appui 14B qu'il porte, le bras élastiquement déformable 15 est replié sur lui-même, suivant en pratique un coude en V.

Il s'agit, comme précédemment, d'une lame de ressort.

Dans la forme de réalisation représentée, le bras élastiquement déformable 15 est solidaire, à sa racine, d'un flasque 25 par lequel il est rapporté sur l'embase 13, à la manière des plots d'appui 14A fixes.

Si désiré, et tel que schématisé en traits interrompus sur la figure 5, ce flasque 25 peut avoir un prolongement 26, qui s'étend circulairement le long de l'embase 13 du côté suivant lequel s'étend lui-même le bras élastiquement déformable 15, pour contrebuter éventuellement ce dernier.

Comme précédemment, enfin, le plot d'appui 14B porté par le bras élastiquement déformable 15 est d'un seul tenant avec celui-ci, en étant formé par un retour en équerre de son extrémité libre.

Dans les variantes de réalisation représentées sur les figures 7 et 8, les plots d'appui 14A fixes s'étendent de part et d'autre de l'embase 13, en étant simplement adossés, et solidarisés, à la tranche interne de l'ouverture centrale 23 de celle-ci.

Par exemple, figure 7, il s'agit, comme précédemment, de tronçons de cylindre droits et lisses, ou comportant localement une ou plusieurs encoches.

En variante, figure 8, l'un au moins de ces plots d'appui 14A fixes est cranté sur toute sa hauteur, et, si désiré, il en est de même pour le plot d'appui 14B associé.

Bien entendu, il est préférentiellement fait en sorte que ce plot d'appui 14B s'étende lui aussi de part et d'autre de l'embase 13.

Quoi qu'il en soit, lorsque l'embase 13 se présente ainsi sous la forme générale d'une rondelle, sa dimension radiale D1 reste, suivant l'invention, au moins égale à sa dimension axiale D2, en étant en pratique un multiple de cette dernière.

A la figure 9, on a représenté une variante de réalisation analogue à celles des figures 5 à 8. L'embase 13 est donc, comme précédemment, ajourée par une large ouverture centrale 23, si bien qu'elle se présente sous la forme générale d'une rondelle. La surface d'appui 16 est formée par sa surface inférieure. Les plots d'appui fixes 14A s'étendent en bordure de cette ouverture centrale 23.

Le plot d'appui mobile 14B est porté par un élément élastiquement déformable 15. Toutefois, à la différence des modes de réalisation représentés aux figures 5 à 8, cet élément 15 se présente sous la forme d'une simple lame droite ou légèrement courbée qui coopère par chacune de ses deux extrémités avec la bordure de l'ouverture centrale 23 et qui porte en son milieu le plot d'appui mobile 14B.

Plus précisément, dans l'exemple illustré, la lame 15 possède deux extrémités 27, 28 qui sont solidaires de l'embase 13 et qui sont à cet effet encastrées dans deux blocs d'encastrement 29, 30 correspondants rapportés sur l'embase 13. Plus précisément, l'extrémité 28 de la lame 15 n'est pas strictement encastrée dans le bloc 30, mais jouit d'une liberté de mouvement suivant la direction longitudinale de la lame 15. La lame 15 peut ainsi se fléchir avec une raideur d'élasticité élevée propre à un maintien ferme d'une lentille entre le plot d'appui mobile 14B et les deux plots d'appui fixes 14A.

Le plot d'appui mobile 14B se présente sous la forme d'un tronçon cylindrique droit, lisse ou pourvu d'aspérités.

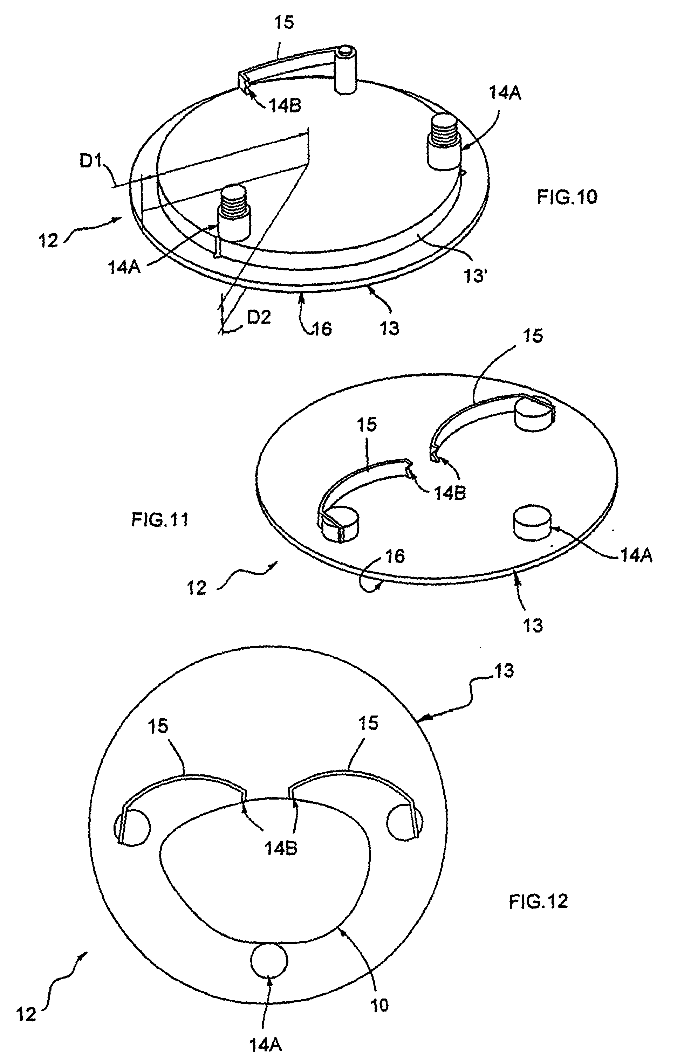

Dans la forme de réalisation représentée sur la figure 10, l'embase 13 est un disque plein, comme dans la forme de réalisation représentée sur les figures 1 à 4.

Mais, dans cette forme de réalisation, cette embase 13 est étagée, avec, dans sa zone médiane, une partie de plus grande épaisseur 13', qui porte les plots d'appui 14A, 14B.

Mais, suivant l'invention, la dimension radiale D1 de cette embase 13 reste au moins égale à sa dimension axiale D2.

Pour le reste, les dispositions sont d'ailleurs sensiblement de même type que celles décrites en référence aux figures 1 à 4.

Mais, cependant, dans la forme de réalisation représentée, l'angle au centre du secteur circulaire suivant lequel s'étend le bras élastiquement déformable 15 est très inférieur à 90°, en étant par exemple de l'ordre de 45°.

En outre, dans la forme de réalisation représentée, les plots d'appui 14A fixes ont une base cylindrique lisse de diamètre supérieur à celui de leur partie supérieure, qui, elle, présente des stries ou des encoches.

Dans la forme de réalisation représentée sur les figures 11 et 12, deux plots d'appui 14A, 14B sont portés chacun respectivement par un bras élastiquement déformable 15, seul le troisième étant fixe.

Autrement dit, dans cette forme de réalisation, il y a un plot d'appui 14A fixe unique et deux plots d'appui 14B portés par des bras élastiquement déformables 15.

Pour le reste, les dispositions sont sensiblement de même type que celles décrites en référence aux figures 1 à 4.

Mais, à titre de variante, le support 12 correspondant a été appliqué au maintien d'une lentille optique 10 dont le contour n'est pas circulaire.

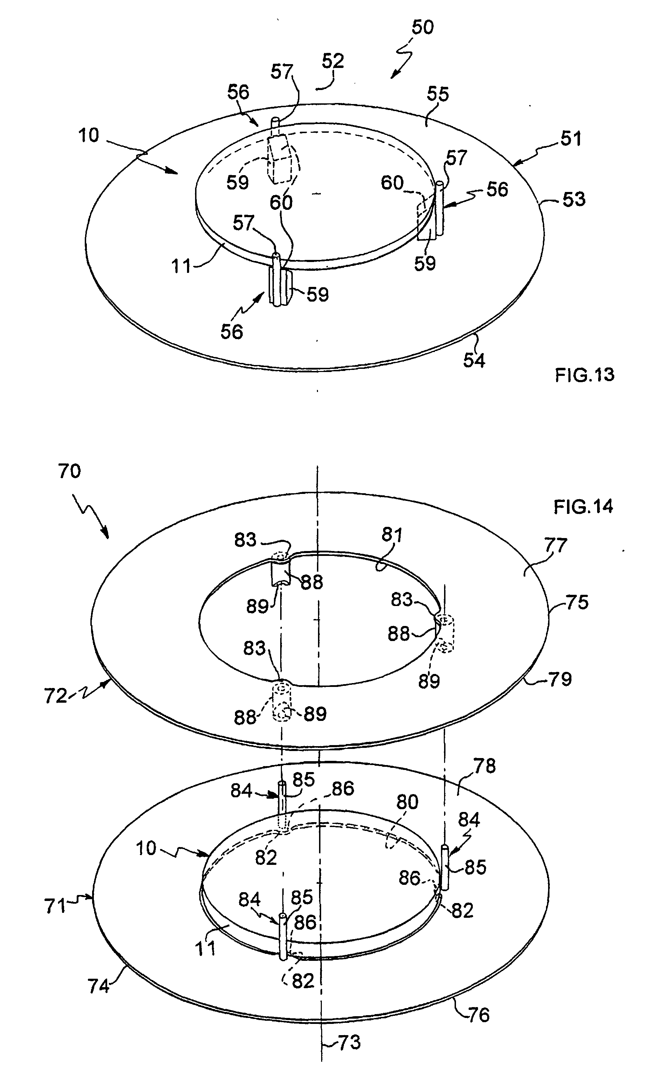

A la figure 13, on a représenté un autre mode de réalisation de l'invention, dans lequel les plots sont fixes sur l'embase.

Plus précisément, dans ce mode de réalisation, le support, désigné par la référence générale 50, comporte une embase 51 qui se présente sous la forme d'un disque plein ayant un axe centrale 52 et présentant un contour circulaire 53 centré sur cet axe. Le disque d'embase 51 possède une première face 54, qui est en pratique sa face inférieure et qui constitue une surface d'appui pour sa propre assise sur le plateau tournant d'un appareil de "spin coating". Comme précédemment, et comme cela ressort de la définition même d'un disque, le disque d'embase 51 présente un rayon très nettement supérieur à son épaisseur. Le disque d'embase 51 offre ainsi une surface d'appui 54 suffisamment étendue pour permettre sa fixation stable par exemple par un système de ventouse pneumatique équipant le plateau tournant de l'appareillage de "spin coating".

Le disque d'embase 51 présente, du côté opposé à sa première face 54, une seconde face 55 qui est en pratique sa face supérieure.

En saillie de sa face supérieure 55, le disque d'embase 51 est pourvu de trois plots d'appui 56 identiques qui sont régulièrement répartis autour de l'axe central 52 pour former un siège de maintien de la lentille 10.

Plus précisément, chacun des trois plots 56 se compose d'un ergot 57 en forme de barrette cylindrique dont l'extrémité inférieure est encastrée dans le disque d'embase 51 qui s'étend parallèlement à l'axe 52, c'est-à-dire verticalement, et d'un bloc 59 qui est fixé à sa base sur la face supérieure 55 du disque d'embase 51 et qui possède une face supérieure 60 taillée en biseau, c'est-à-dire s'étendant dans un plan oblique par rapport aux faces 54 et 55 du disque d'embase 51, c'est-à-dire par rapport à l'horizontale. En l'espèce, la face supérieure 60 du bloc 59 est inclinée d'un angle d'environ 50° par rapport à l'horizontal. Les faces supérieures 60 des blocs 59 sont en outre disposées de manière à converger en direction de l'axe central 52, vers le disque d'embase 51, c'est-à-dire vers le bas, de manière à offrir à la lentille 10 un siège pseudo-conique.

Chaque plot 56 présente ainsi, pour la lentille 10, d'une part une face d'appui radial constituée par la surface latérale des ergots 57 et d'autre part une face d'appui axial constituée par la face supérieure 60 des blocs 59.

Le fait que les faces d'appui axial 60 des blocs 56 soient en biseau permet de réduire le contact de la lentille avec les plots 56 à une simple ligne, voire un simple point, situé en bordure de cette lentille, ce qui préserve l'intégrité entière de la face inférieure de la lentille 10. Cette disposition augmente en outre la stabilité de l'assise de la lentille.

On observera par ailleurs que les faces d'appui axial 60 présentées par les blocs 59 offrent à la lentille 10 une assise dans un plan qui est parallèle à la face supérieure 55 du disque d'embase 51 et qui est légèrement surélevé par rapport à celle-ci. La face inférieure de la lentille 10 est donc gardée à distance de la face supérieure 55 du disque d'embase 51.

Aux figures 14 à 16, on a représenté encore un autre mode de réalisation comportant deux embases à plots fixes prenant la lentille en sandwich.

Plus précisément, le support présenté ici, désigné par la référence générale 70, comporte deux embases en forme générale de disque, dont une première embase 71 et une seconde embase 72.

En l'espèce, les deux embases 71 et 72 sont identiques et possèdent un axe central commun 73 vertical.

Chaque embase 71, 72 possède un contour circulaire 74, 75 centré sur l'axe 73, une première face 76, 77 et une seconde face 78, 79, opposée à la première.

Les disques d'embase 71, 72 sont en outre ajourés par une ouverture centrale délimitée par une bordure intérieure 80, 81 qui est de forme sensiblement circulaire, centrée sur l'axe 73 et qui, plus précisément, présente sensiblement la même forme et la même dimension que la lentille 10.

Les bordures intérieures 80, 81 des disques d'embase 71, 72 ne sont toutefois pas rigoureusement circulaires : elles présentent des saillies radiales arrondies 82, 83 qui sont ici au nombre de trois, régulièrement réparties autour de l'axe central 73.

Chacun des disques d'embase 71, 72 possède trois plots d'appui fixes servant au maintien de la lentille 10 et disposés en saillie de leur seconde face 78, 79 au niveau des saillies radiales 82, 83 de la bordure intérieure des embases 71, 72. Toutefois, les plots équipant le premier disque d'embase 71 diffèrent de ceux équipant le second disque d'embase 72.

Les plots du premier disque d'embase 71, désignés par la référence générale 84, se composent chacun d'une part d'un ergot 85 constitué par une barrette cylindrique encastrée à l'une de ses extrémités dans le disque d'embase 71 et s'étendant parallèlement à l'axe central 73, c'est-à-dire verticalement, et d'autre part de la saillie correspondante 82 du disque d'embase 71. L'ergot 85 de chaque plot d'appui 84 présente ainsi une surface périphérique cylindrique qui constitue une face d'appui radial pour la tranche 11 de la lentille 10. L'ergot 85 de chaque plot 84 est agencé de telle sorte que sa surface périphérique, qui constitue la face d'appui radial du plot 84 concerné, affleure un cylindre imaginaire d'axe 73 contenant la bordure intérieure 80 du disque d'embase 71. De la sorte, la lentille 10 est logée quasiment sans jeu radial entre les ergots 85 des plots 84. Les saillies radiales 82 du premier disque d'embase 71 présentent quant à elle, dans la continuité de la seconde face 78 de ce disque d'embase, une face d'appui axial 86. Les faces d'appui axial 86 des trois saillies 82 offrent ainsi pour la lentille 10 une assise dans un plan horizontal qui se confond avec celui de la seconde face 78 du premier disque d'embase 71. On comprend donc que les saillies 82 du disque d'embase 71 font partie intégrante des plots 84 de maintien de la lentille 10.

Les plots d'appui du second disque d'embase 72 sont quant à eux constitués par des bornes 88 fixées par leur base sur la seconde face 79 du second disque d'embase 72, au niveau des saillies radiales 83.

Chacune de ces bornes 88 présente à son sommet, c'est-à-dire à l'opposé de sa base qui est fixée au disque d'embase 72, une face d'appui axial 89 qui, en l'espèce, est biseautée, c'est-à-dire qui s'étend dans un plan oblique par rapport aux faces 77, 79 du second disque d'embase 76, c'est-à-dire par rapport à l'horizontale. En l'espèce, cette face d'appui axial biseautée 89 forme par rapport à l'horizontal un angle a d'environ 50°. Les faces d'appui axial biseautées 89 des trois bornes 88 convergent vers l'axe central 73 et vers le second disque d'embase 72, de manière à offrir à la lentille 10 un siège pseudo-conique sur lequel elle repose exclusivement par son bord périphérique, comme cela sera mieux expliqué ultérieurement.

Chaque borne 88 présente de plus un logement axial agencé pour recevoir avec un faible jeu l'ergot 85 du plot correspondant 84 du premier disque d'embase 71. Les ergots 85 du premier disque d'embase 71 et les bornes 88 du second disque d'embase 72 constituent ainsi des moyens d'emboîtement homologues qui réalisent un assemblage des deux disques d'embase 71 et 72 avec un positionnement relatif précis de ces derniers.

Comme illustré à la figure 14, les logements 90 des bornes 88 sont débouchants de part et d'autre de la borne et en particulier à sa base où il débouche sur la seconde face 79 du second disque d'embase 72. Ainsi, la face 79 constitue-t-elle le fond du logement 90 des bornes 88.

En service, l'assemblage du support à double embase qui vient d'être décrit, s'effectue de la manière suivante.

Le premier disque d'embase 71 est disposé dans la configuration représentée à la figure 14, c'est-à-dire à l'horizontal, avec son axe central 73 vertical et sa surface d'appui 76 tournée vers le bas.

La lentille 10 est insérée entre les ergots 85 de manière à venir reposer sur les faces d'appui axial 86 présentées par les saillies radiales 82. Dans cet état, la face inférieure de la lentille 10, qui n'a pas encore été traitée, et qui ne fait encore l'objet d'aucun traitement, est localement en contact avec les saillies 82. Ce contact n'est cependant pas pénalisant car, d'une part il s'étend sur une surface très réduite, et d'autre part la face inférieure de la lentille 10 n'est revêtue d'aucun traitement de surface.

Le second disque d'embase 72 est ensuite placé en recouvrement du premier disque 71, comme illustré dans la figure 14. A cet effet, le second disque 72 est disposé à l'horizontale, coaxialement au premier disque 71, c'est-à-dire selon l'axe central 73 commun, avec sa surface d'appui 77 tournée vers le haut, les faces 78 et 79 des deux disques d'embase 71 et 72 étant en regard. Le second disque 72 est calé angulairement, de telle sorte que les logements 90 des bornes 88 soient sensiblement calés sur les axes des ergots 85 des plots 84 du premier disque d'embase 71. Les bornes 88 peuvent alors être emmanchées sur les ergots 85. L'extrémité libre des ergots 85 vient en butée dans le fond des logements 90 des bornes 88, c'est-à-dire contre la face 79 du second disque d'embase 72, sans que les faces d'appui axial 89 des bornes 88 viennent au contact de la lentille 10. La face supérieur de la lentille 10 est ainsi préservée de tout contact avec le second disque d'embase 72.

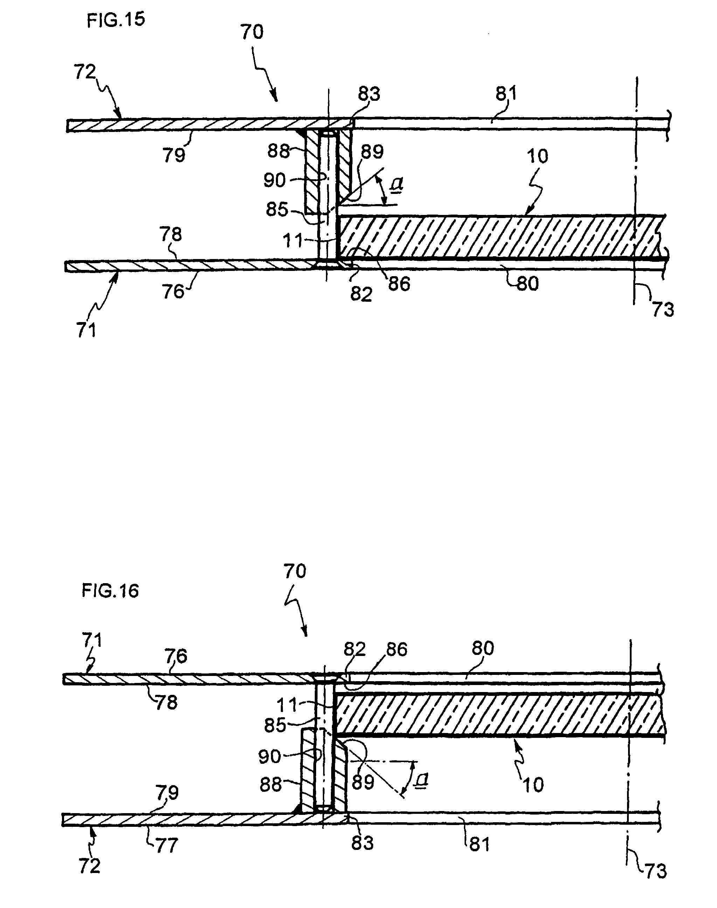

L'ensemble du support, avec ses ceux embases superposées, et la lentille 10 entre eux, peut alors être placée, dans la configuration illustrée dans les figures 14 et 15, sur le plateau tournant d'un appareillage de "spin coating", avec la surface d'appui 76 du premier disque d'embase 71 reposant sur ce plateau. La première face de la lentille 10 qui est tournée vers le haut, peut alors être traitée.

Après traitement de cette première face, l'ensemble du support avec la lentille est retourné est la surface d'appui 77 du second disque d'embase 72 est placé sur le plateau tournant de l'appareillage du "spin coating". Lors du retournement du support, la lentille 10, qui jouit d'un certain jeu entre les plans d'assise ménagés par les surfaces d'appui axial associées aux deux embases, descend légèrement pour venir reposer sur les faces d'appui axial 89 présentées par les bornes 88 du second disque d'embase 72. La seconde face de la lentille, qui se trouve désormais orientée vers le haut, est alors dégagée de tout contact avec le premier disque d'embase 71.

De son côté, l'autre face de la lentille 10 qui est tournée vers le bas et qui vient de subir un traitement, ne repose sur les faces d'appui axial 89 en biseau que par une ligne ou un simple point d'appui situé sur sa périphérie. Cette face de la lentille 10 est donc préservée de tout contact avec le second disque d'embase 72, comme cela est visible à la figure 16. Le traitement de surface qui vient d'être déposé sur cette face inférieure de la lentille 10 ne risque donc pas d'être détérioré.

La seconde face de la lentille 10 qui est tournée vers le haut, peut alors être traitée.

## Revendications

1. Support pour lentille optique du genre comportant au moins une première embase (13), et, portés par celle-ci, pour le maintien d'une telle lentille optique (10) par sa tranche (11), au moins trois plots d'appui (14A, 14B), **caractérisé en ce que** l'embase (13) comporte, pour sa propre assise, une surface d'appui (16), qui est plane, et dont le contour périphérique (P1) est globalement circulaire, et **en ce que** la dimension radiale (D1) de ladite embase (13) suivant un quelconque rayon (R) de cette surface d'appui (16) est au moins égale à la dimension axiale (D2) de ladite embase (13) suivant une perpendiculaire à ladite surface d'appui (16).

2. Support suivant la revendication 1, **caractérisé en ce que**, parmi les trois plots d'appui, un au moins est fixe par rapport à l'embase (13) et un autre (14B), au moins, est porté par un élément élastiquement déformable (15) lui-même porté par l'embase (13).

3. support suivant la revendication 2, **caractérisé en ce que** deux plots d'appui (14A) sont fixes, seul le troisième (14B) étant porté par un élément élastiquement déformable (15).

4. Support suivant la revendication 3, **caractérisé en ce que** l'élément élastiquement déformable (15) est un bras élastique ancré à sa racine dans l'un des plots d'appui (14A) fixes.

5. Support suivant la revendication 2, **caractérisé en ce que** deux plots d'appui (14B) sont portés chacun respectivement par un élément élastiquement déformable (15), seul le troisième (14A) étant fixe.

6. Support suivant l'une quelconque des revendications 2 à 5, **caractérisé en ce que** le plot (14B) porté par un élément élastiquement déformable (15) est d'un seul tenant avec celui-ci.

7. Support suivant l'une quelconque des revendications 2 à 6, **caractérisé en ce que** l'élément élastiquement déformable (15) est un bras qui, entre sa racine et le plot d'appui (14B) qu'il porte, est replié sur lui-même.

8. Support selon l'une quelconque des revendications 2 à 7, **caractérisé en ce que** l'élément élastiquement déformable (15) est un bras élastique formé par une lame de ressort dont la largeur s'étend perpendiculairement au plan de la surface d'appui (16) de l'embase (13).

9. Support suivant l'une quelconque des revendications 2 à 8, **caractérisé en ce que** l'embase (13) est ajourée par une ouverture centrale (23), et le ou les plots d'appui (14A) fixes s'étendent en bordure de cette ouverture centrale (23). le ou les plots d'appui (14B) portés par un élément élastiquement déformable (15) s'étendant dans le contour même de celle-ci.

10. Support suivant la revendication 9, **caractérisé en ce que** les plots d'appui (14A, 14B) s'étendent de part et d'autre de l'embase (13).

11. Support suivant l'une quelconque des revendications 2 à 10, **caractérisé en ce que** l'un au moins des plots d'appui (14A, 14B) présente localement au moins une encoche (21).

12. Support suivant l'une quelconque des revendications 2 à 10, **caractérisé en ce que** l'un au moins des plots d'appui (14A, 14B) est cranté sur toute sa hauteur.

13. Support suivant l'une quelconque des revendications 2 à 12, **caractérisé en ce que** les plots d'appui (14A, 14B) interviennent, au repos, suivant une circonférence (P2) excentrée par rapport au contour périphérique (P1) de la surface d'appui (16) de l'embase (13), le centre (C2) de cette circonférence (P2) se situant plus près du ou des plots d'appui (14A) fixes que le centre (C1) de ce contour périphérique (P1).

14. Support suivant la revendication 1, **caractérisé en ce que** les trois plots d'appui (56 ; 84, 88) sont fixes sur l'embase (51 ; 71, 72) et présentent chacun une face d'appui radial (57, 85) et une face d'appui axial (60, 89, 86), les faces d'appui axial des différents plots offrant à la périphérie de la lentille une assise suivant un plan donné parallèle à la surface d'appui de l'embase.

15. Support suivant la revendication 14, **caractérisé en ce que** l'embase (51 ; 71, 72) se présente sous la forme générale d'un disque, dont l'une des faces (54 ; 76, 77) constitue la surface d'appui pour sa propre assise et dont l'autre face est pourvue, en saillie, des plots d'appui.

16. Support suivant la revendication 15, **caractérisé en ce que** l'embase (51) se présentant sous la forme d'un disque plein, le plan d'assise offert par les faces d'appui axial des plots s'étend légèrement à distance de cette autre face de l'embase.

17. Support suivant la revendication 15, **caractérisé en ce que** l'embase (71) se présentant sous la forme générale d'un disque ajourée par une ouverture centrale délimitée par une bordure intérieure (80) sensiblement de même forme et de même dimension que la lentille (10), les plots d'appui (84) sont réalisés chacun en deux parties, avec une première partie (85) qui fait saillie de l'autre face de l'embase et présente la face d'appui radial du plot concerné et une seconde partie (82) qui s'étend en saillie radiale de la bordure intérieure de l'embase.

18. Support suivant la revendication 17, **caractérisé en ce que** la seconde partie (82) de chaque plot est réalisée en une seule pièce avec l'embase (71).

19. Support suivant l'une des revendications 14 à 18, **caractérisé en ce que** les faces d'appui axial des plots (60) sont en biseau convergeant vers l'intérieure et vers l'embase (51).

20. Support suivant l'une des revendications 14 à 19, **caractérisé en ce qu'**il comporte une seconde embase (72) analogue à la première, pourvue d'au moins trois plots d'appui (88) pour le maintien de la lentille (10) et comportant, pour sa propre assise, une surface d'appui (77) plane dont le contour périphérique est globalement circulaire, sa dimension radiale suivant un quelconque rayon de cette surface d'appui étant au moins égale à sa dimension axiale suivant une perpendiculaire au plan de celle-ci, **en ce que** les plots (88) de la seconde embase (72) présentent des faces d'appui axial (89) offrant à la lentille (10) une assise suivant un plan parallèle à la surface d'appui (77) de la seconde embase pour sa propre assise, et **en ce que** les deux embases (71, 72) sont pourvues de moyens (85, 88) de leur assemblage en superposition, avec la surface d'appui (76, 77) de chaque embase tournée à l'opposé de l'autre embase, de telle sorte que les deux assises offertes par les faces d'appui axial des plots des deux embases prennent la périphérie de la lentille (10) en sandwich.

21. Support suivant la revendication 20, **caractérisé en ce que** les deux plans des assises offertes par les faces d'appui axial (86, 89) des plots des deux embases (71, 72) sont distants l'un de l'autre d'une distance légèrement supérieure à l'épaisseur de la lentille (10), de sorte que celle-ci jouit d'un certain jeu axial entre les deux plans d'assise associés aux deux embases.

22. Support suivant l'une des revendications 20 et 21, **caractérisé en ce que** les moyens d'assemblage des deux embases l'une sur l'autre font intervenir les plots d'appui (85, 88).

23. Support suivant la revendication 22, **caractérisé en ce que** les plots d'appui (84) de la première embase comportent chacun un ergot (85) qui s'étend axialement, à l'opposé de la surface d'appui (76) de l'embase (71), et qui porte la face d'appui radial du plot concerné, et **en ce que** les plots de la seconde embase comportent chacun une borne (88) portant la face d'appui axial (89) du plot concerné et présentant un logement axial de réception de l'ergot (85) d'un plot (84) correspondant de la première embase (71).

24. Support suivant les revendications 22 et 23, **caractérisé en ce que** l'écartement des deux embases (71, 72) et, partant, des plans d'assise qui sont offerts par les face d'appui axial de leur plot, est déterminé par la butée de l'extrémité libre des ergots (85) des plots (84) de la première embase contre un fond des logements (90) des bornes (88) des plots de la seconde embase (72).

25. Support suivant la revendication 24, **caractérisé en ce que** les logements (90) des bornes (88) des plots de la seconde embase (72) sont débouchant, le fond du logement de chaque borne étant constitué par une surface (79) de la seconde embase elle-même (72), de laquelle ladite borne fait saillie.

26. Support suivant l'une des revendications 20 à 25, **caractérisé en ce que** les faces d'appui axial (89) des plots de la seconde embase (72) sont en biseau.

27. Support suivant l'une des revendications 20 à 26, **caractérisé en ce que** chacune des deux embases (71, 72) se présente sous la forme générale d'un disque ajouré par une ouverture centrale délimitée par une bordure intérieure (80, 81) sensiblement de même forme et de même dimension que la lentille.

28. Utilisation d'un support selon l'une des revendications 1 à 27 au sein d'un appareillage mettant en oeuvre la technique du "spin coating", dans laquelle ledit support est fixé par sa seule surface d'appui (16) sur un plateau tournant dudit appareillage, lequel plateau tournant présente une pluralité d'orifices d'aspiration maintenant l'embase (13) contre ledit plateau par succion de sa surface d'appui (16).

## Claims

1. An optical lens support of the kind including at least one first base (13) and, carried thereby, for holding such an optical lens (10) by its edge (11), at least three bearing studs (14A, 14B), **characterized in that** the base (13) includes for its own seating, a plane bearing surface (16) whose peripheral contour (P1) is globally circular, and **in that** the radial dimension (D1) of said base (13) along any radius (R) of that bearing surface (16) is at least equal to the axial dimension (D2) of said base (13) perpendicular to said bearing surface (16) thereof.

2. A support according to claim 1, **characterized in that** at least one of the three bearing studs is fixed relative to the base (13) and at least one other stud (14B) is carried by an elastically deformable member (15) itself carried by the base (13).

3. A support according to claim 2, **characterized in that** two bearing studs (14A) are fixed and only the third stud (14B) is carried by an elastically deformable member (15).

4. A support according to claim 3, **characterized in that** the elastically deformable member (15) is an elastic arm with its root anchored in one of the fixed bearing studs (14A).

5. A support according to claim 2, **characterized in that** two bearing studs (14B) are each respectively carried by an elastically deformable member (15), only the third stud (14A) being fixed.

6. A support according to any one of claims 2 to 5, **characterized in that** the stud (14B) carried by an elastically deformable member (15) is in one piece therewith.

7. A support according to any one of claims 2 to 6, **characterized in that** the elastically deformable member (15) is an arm which is bent on itself between its root and the bearing stud (14B) that it carries.

8. A support according to any one of claims 2 to 7, **characterized in that** the elastically deformable member (15) is an elastic arm formed by a leaf spring whose width is perpendicular to the plane of the bearing surface (16) of the base (13).

9. A support according to any one of claims 2 to 8, **characterized in that** the base (13) has a central opening (23) in it, the fixed bearing stud or studs (14A) is or are at the border of the central opening (23), and the bearing stud or studs (14B) carried by an elastically deformable member (15) is or are inside the contour thereof.

10. A support according to claim 9, **characterized in that** the bearing studs (14A, 14B) extend both sides of the base (13).

11. A support according to any one of claims 2 to 10, **characterized in that** at least one of the bearing studs (14A, 14B) has at least one localized notch (21).

12. A support according to any one of claims 2 to 10, **characterized in that** at least one of the bearing studs (14A, 14B) is notched over its entire height.

13. A support according to any one of claims 2 to 12, **characterized in that** the bearing studs (14A, 148) are operative, when not in use, along a circumference (P2) that is eccentric to the peripheral contour (P1) of the bearing surface (16) of the base (13), the center (C2) of the circumference (P2) being closer to the fixed bearing stud or studs (14A) than the center (C1) of the peripheral contour (P1).

14. A support according to claim 1, **characterized in that** the three bearing studs (56; 84, 88) are fixed to the base (51; 71, 72) and each has a radial bearing face (57, 85) and an axial bearing face (60, 89, 86), the axial bearing faces of the different studs offering a seating for the periphery of the lens in a specific plane parallel to the bearing surface of the base.

15. A support according to claim 14, **characterized in that** the base (51; 71, 72) takes the general form of a disk, one face (54; 76, 77) of which constitutes the bearing surface for its own seating and the other face of which has bearing studs projecting from it.

16. A support according to claim 15, **characterized in that**, the base (51) taking the form of a solid disk, the seating plane offered by the axial bearing faces of the studs is at a small distance from the other face of the base.

17. A support according to claim 15, **characterized in that**, the base (71) taking the general form of a disk with a central opening in it delimited by an inside edge (80) substantially the same shape and the same size as the lens (10), the bearing studs (84) are each made in two parts, with a first part (85) which projects from the other face of the base and features the radial bearing face of the stud concerned and a second part (82) which projects radially from the inside edge of the base.

18. A support according to claim 17, **characterized in that** the second part (82) of each stud is formed in a single piece with the base (71).

19. A support according to any one of claims 14 to 18, **characterized in that** the axial bearing faces of the studs (60) are beveled and converge toward the inside and toward the base (51).

20. A support according to any one of claims 14 to 19, **characterized in that** it includes a second base (72) analogous to the first base, having at least three bearing studs (88) for holding the lens (10), and including, for its own seating, a plane bearing surface (77) whose peripheral contour is globally circular, its radial dimension along any radius of the bearing surface being at least equal to its axial dimension perpendicular to the plane thereof, **in that** the studs (88) of the second base (72) have axial bearing faces (89) offering a seating for the lens (10) in a plane parallel to the bearing surface (77) of the second base for its own seating, and **in that** the two bases (71, 72) are provided with means (85, 88) for assembling them together in a superposed arrangement, with the bearing surface (76, 77) of each base facing away from the other base, so that the two seatings offered by the axial bearing faces of the studs of the two bases sandwich the periphery of the lens (10).

21. A support according to claim 20, **characterized in that** the two seating planes offered by the axial bearing faces (86, 89) of the studs of the two bases (71, 72) are separated by a distance slightly greater than the thickness of the lens (10) so that the lens has the benefit of some axial clearance between the two seating planes associated with the two bases.

22. A support according to either claim 20 or claim 21, **characterized in that** the means for assembling the two bases one on top of the other make use of the bearing studs (85, 88).

23. A support according to claim 22, **characterized in that** the bearing studs (84) of the first base each include a lug (85) which extends axially away from the bearing surface (76) of the base (71) and carries the radial bearing face of the stud concerned, and **in that** the studs of the second base each comprise a post (88) carrying the axial bearing face (89) of the stud concerned and providing an axial housing to receive the lug (85) of a corresponding stud (84) of the first base (71).

24. A support according to claims 22 and 23, **characterized in that** the distance between the two bases (71 and 72) and therefore between the seating planes offered by the axial bearing faces of their studs is determined by abutting of the free ends of the lugs (85) of the studs (84) on the first base against an end wall of the housings (90) of the posts (88) of the studs of the second base (72).

25. A support according to claim 24, **characterized in that** the housings (90) of the posts (88) of the studs of the second base (72) are open, the end wall of the housing of each post consisting of a surface (79) of the second base (72) itself, from which said post projects.

26. A support according to any one of claims 20 to 25, **characterized in that** the axial bearing faces (89) of the studs of the second base (72) are beveled.

27. A support according to any one of claims 20 to 26, **characterized in that** each of the two bases (71, 72) is in the general form of a disk with a central opening in it delimited by an inside edge (80, 81) substantially the same shape and the same size as the lens.

28. The use of a support according to one of claims 1 to 27 within an apparatus implementing the "spin coating" technique, in which said support is fixed solely by its bearing surface (16) onto a turntable of said apparatus, said turntable having a plurality of suction orifices holding the base (13) against said turntable by suction of its bearing surface (16).

## Patentansprüche

1. Optische-Linsenstützvorrichtung, vom Typ umfassend eine erste Basis (13) und an dieser gestützt zum Zwecke der Halterung einer optischen Linse (10) an dem Rand (11) davon zumindest drei Anlagestellen (14A, 14B), **dadurch gekennzeichnet, daß** die Basis (13) zum Zwecke der eigenen Lagerung eine Anlagefläche (16) umfaßt, die eben bzw. planar ist, und dessen peripherer Umriß (P1) global kreisförmig ist, und daß radiale Abmessung (D1) der Basis (13) entlang eines beliebigen Radius (R) dieser Anlage- oder Auflagefläche (16) zumindest gleich ist zu der axialen Abmessung (D2) der Basis (13), entsprechend einer Senkrechten zu der Anlagefläche (16) davon.

2. Stützvorrichtung nach Anspruch 1, **dadurch gekennzeichnet, daß** unter den drei Anlagestellen zumindest eine feststehend mit Bezug auf die Basis (13) ist, wobei zumindest eine Andere (14B) durch ein elastisch verformbares Element (15) gestützt ist, welches wiederum von der Basis (13) gestützt wird.

3. Stützvorrichtung nach Anspruch 2, **dadurch gekennzeichnet, daß** zwei Anlagestellen (14A) feststehend sind, wobei lediglich die dritte (14B) von einem elastisch verformbaren Element (15) gestützt wird.

4. Stützvorrichtung nach Anspruch 3, **dadurch gekennzeichnet, daß** das elastisch verformbare Element (15) ein elastischer Arm ist, in seiner Wurzel verankert an einer der feststehenden Anlagestellen (14A).

5. Stützvorrichtung nach Anspruch 2, **dadurch gekennzeichnet, daß** zwei Anlagestellen (14B) jeweils von einem elastisch verformbaren Element (15) gestützt sind, wobei lediglich die dritte (14A) feststehend ist.

6. Stützvorrichtung nach einem der Ansprüche 2 bis 5, **dadurch gekennzeichnet, daß** die Stelle (14B), die von einem elastisch verformbaren Element gestützt ist, diesbezüglich einstückig vorliegt.

7. Stützvorrichtung nach einem der Ansprüche 2 bis 6, **dadurch gekennzeichnet, daß** das elastisch verformbare Element (15) ein Arm ist, der zwischen seiner Wurzel und dem Anlagepunkt (14B), den er trägt bezüglich sich selbst, zurückgeschlagen oder zurückgefaltet ist.

8. Stützvorrichtung nach einem der Ansprüche 2 bis 7, **dadurch gekennzeichnet, daß** das elastisch verformbare Element (15) ein elastischer Arm ist, gebildet durch ein Federblatt, dessen Breite sich senkrecht zur Ebene der Anlagefläche (16) der Basis (13) erstreckt.

9. Stützvorrichtung nach einem der Ansprüche 2 bis 8, **dadurch gekennzeichnet, daß** die Basis (13) von einer mittleren Öffnung (23) durchquert wird, wobei die Anlageflächen (14A), die feststehend sind, sich am Rand dieser mittleren Öffnung (23) erstrecken, wobei die von einem elastisch verformbaren Element (15) gestützte bzw. gestützten Anlagestelle(n) (14B) sich in der Kontur bzw. dem Umriß selbst davon erstrecken.

10. Stützvorrichtung nach Anspruch 9, **dadurch gekennzeichnet, daß** die Anlagestellen (14A, 14B) sich beidseitig der Basis (13) erstrecken.

11. Stützvorrichtung nach einem der Ansprüche 2 bis 10, **dadurch gekennzeichnet, daß** zumindest eine Anlagestelle (14A, 14B) lokal zumindest eine Kerbe (21) aufweist.

12. Stützvorrichtung nach einem der Ansprüche 2 bis 10, **dadurch gekennzeichnet, daß** zumindest eine der Anlagestellen (14A, 14B) bezüglich der gesamten Höhe gerastet/gerippt ist.

13. Stützvorrichtung nach einem der Ansprüche 2 bis 12, **dadurch gekennzeichnet, daß** die Anlagestellen (14A, 14B) im Ruhezustand wirken bei einem Umfang (P2), der exzentrisch vorliegt mit Bezug auf die periphere Kontur (P1) der Anlagefläche (16) der Basis (13), wobei die Mitte (C2) dieses Umfanges (P2) sich näher an den oder dem feststehenden Anlagestellen (14A) befindet, als die Mitte bzw. das Zentrum (C1) der peripheren Kontur bzw. des peripheren Umrisses oder Umfanges (P1).

14. Stützvorrichtung nach Anspruch 1, **dadurch gekennzeichnet, daß** die drei Anlagestellen (56; 84, 88) feststehend an der Basis (51; 71, 72) vorliegen und jeweils eine radiale Anlagefläche (57, 85) und eine axiale Anlagefläche (60, 89, 86) aufweisen, wobei die axialen Anlageflächen der unterschiedlichen Stellen der Peripherie der Linse eine Halterung bereitstellen entsprechend einer gegebenen Ebene, die parallel zur Anlagefläche der Basis vorliegt.

15. Stützvorrichtung nach Anspruch 14, **dadurch gekennzeichnet, daß** die Basis (51; 71, 72) in der generellen Form einer Scheibe vorliegt, von der eine der Flächen (54; 76, 77) die Anlagefläche ausbildet zum Zwecke der eigenen Halterung oder Lagerung, und dessen andere Fläche vorspringend mit Anlagestellen bereitgestellt ist.

16. Stützvorrichtung nach Anspruch 15, **dadurch gekennzeichnet, daß** die Basis (51) die Form einer Vollscheibe aufweist, wobei sich die durch die axialen Anlageflächen der Stellen bereitgestellte Halterungs- oder Lagerungsebenen unter geringerem Abstand zu der anderen Fläche der Basis erstreckt.

17. Stützvorrichtung nach Anspruch 15, **dadurch gekennzeichnet, daß** die Basis (71) sich in der generellen Form einer durchbohrten Scheibe darstellt, durchdrungen von einer mittleren oder zentralen Öffnung, die durch einen Innenrand (80) begrenzt ist, im wesentlichen von entsprechender Form und entsprechender Abmessung bezüglich der Linse (10), wobei die Anlagestellen (84) jeweils zweiteilig dargestellt sind mit einem ersten Teil (85), der von der anderen Fläche der Basis vorspringt, und die radiale Anlagefläche der in Frage stehenden Stelle bereitstellt, und mit einem zweiten Teil (82), der sich radial vorspringend von dem Innenrand der Basis erstreckt.

18. Stützvorrichtung nach Anspruch 17, **dadurch gekennzeichnet, daß** der zweite Teil (82) von jeder Stelle einstückig dargestellt ist mit der Basis (71).

19. Stützvorrichtung nach einem der Ansprüche 14 bis 18, **dadurch gekennzeichnet, daß** die axialen Anlagenflächen der Stellen (60) konvergierend abgeschrägt sind hin zu dem Inneren und hin zu der Basis (51).

20. Stützvorrichtung nach einem der Ansprüche 14 bis 19, **dadurch gekennzeichnet, daß** sie eine zweite Basis (72) umfaßt, analog zu der ersten, bereitgestellt mit zumindest drei Anlagestellen (88) zur Halterung der Linsen (10), und umfassend zur eigenen Stützung oder Lagerung eine Anlagefläche (77), die eben ist, wobei die Kontur oder der Umriß peripher global kreisförmig ist, wobei die radiale Abmessung entsprechend einem beliebigen Radius dieser Anlagefläche zumindest gleich ist zu der axialen Abmessung entsprechend einer senkrechten bzw. normalen zur Ebene davon, und das die Stellen (88) der zweiten Basis (72) axiale Anlageflächen (89) aufweisen, der Linse (10) eine Lagerung oder Halterung bereitstellen entsprechend einer Ebene, parallel zur Anlagefläche (77) der zweiten Basis zum Zwecke der Lagerung, und daß die zwei Basen (71, 72) bereitgestellt sind mit Mitteln (85, 88) zum Zwecke ihrer übereinander angeordneten Montage, wobei die Anlagefläche (76, 77) von jeder Basis entgegengesetzt gerichtet ist zu jener der anderen Basis, so daß die zwei Lagerungen, bereitgestellt durch die axialen Anlageflächen der Stellen der zwei Basen die Peripherie der Linse (10) sandwichartig eingreifen.

21. Stützvorrichtung nach Anspruch 20, **dadurch gekennzeichnet, daß** die zwei Lagerflächen, bereitgestellt durch die axialen Anlageflächen (86, 89) der Stellen der zwei Basen (71, 72) beabstandet mit Bezug zueinander vorliegen, um eine Entfernung leicht größer als die Dicke der Linse (10), so daß diese über ein gewisses axiales Spiel verfügt zwischen den zwei den zwei Basen zugeordneten Lagerebenen.

22. Stützvorrichtung nach einem der Ansprüche 20 und 21, **dadurch gekennzeichnet, daß** die Mittel zur Montage der zwei Basen mit Bezug zueinander Anlagestellen (85, 88) nutzen.

23. Stützvorrichtung nach Anspruch 22, **dadurch gekennzeichnet, daß** die Anlagestellen (84) der ersten Basis jeweils einen Zapfen (85) umfassen, der sich axialwärts erstreckt gegenüberstehend zu der Anlagefläche (76) der Basis (71), wobei der Zapfen (85) die radiale Anlagefläche der in Frage stehenden Stelle trägt, und daß die Stellen der zweiten Basis jeweils eine Steckstelle (88) umfassen, die axiale Anlagefläche (89) der in Frage stehenden Stelle stützend und eine axiale Aufnahme zum Empfangen des Zapfens (85) einer entsprechenden Stelle (84) der ersten Basis (71) aufweisend.

24. Stützvorrichtung nach den Ansprüchen 22 und 23, **dadurch gekennzeichnet, daß** die Beabstandung der zwei Basen (71, 72) und demgemäß der Anlageebenen, die durch die axialen Anlageflächen derer Stellen bereitgestellt sind, bestimmt ist durch den Anschlag des freien Endes der Zapfen (85) der Stellen (84) der ersten Basis gegen einen Boden der Aufnahme (90) der Steckstellen (88) der Stellen der zweiten Basis (72).

25. Stützvorrichtung nach Anspruch 24, **dadurch gekennzeichnet, daß** die Aufnahme (90) der Steckstellen (88) der Stellen der zweiten Basis (72) mündend sind, wobei der Boden der Aufnahme von jeder Steckstelle gebildet ist durch eine Fläche (79) der zweiten Basis (72) selbst, wobei die Steckstelle diesbezüglich vorspringt.

26. Stützvorrichtung nach einem der Ansprüche 20 bis 25, **dadurch gekennzeichnet, daß** die axialen Anlageflächen (89) der Stellen der zweiten Basis (72) abgeschrägt sind.

27. Stützvorrichtung nach einem der Ansprüche 20 bis 26, **dadurch gekennzeichnet, daß** jede der zwei Basen (71, 72) in der generellen Form einer Scheibe vorliegt, durchdrungen von einer mittleren Öffnung, die begrenzt wird, durch einen inneren Rand (80, 81), im wesentlichen von gleicher oder entsprechender Form und gleicher oder entsprechender Abmessung wie die Linse.

28. Verwendung einer Stützvorrichtung nach einem der Ansprüche 1 bis 27 in einem Gerät, welches die "spin coating"-Technik verwendet, wobei die Stützvorrichtung mittels der einzelnen Anlagefläche (16) an einer drehbaren Platte des Gerätes befestigt ist, wobei die Platte eine Vielzahl von Ansaugöffnungen aufweist, die Basis (13) mittels Ansaugung der Anlagefläche (16) gegen die Platte haltend.
